# EUROPÄISCHE PATENTANMELDUNG

(11) **EP 1 217 668 A1**
(43) Veröffentlichungstag der Anmeldung: **26.06.2002**
(21) Anmeldenummer: 00128296.1
(22) Anmeldetag: 22.12.2000
(51) Int. Cl.: H01L 51/30, C07F 5/02, C07F 5/06

(54) **Verwendung von Bor- und Aluminium-Verbindungen in Elektronik-Bauteilen**

(71) Anmelder: Covion Organic Semiconductors GmbH, 65926 Frankfurt (DE)
(72) Erfinder: Die Erfindernennung liegt noch nicht vor

(57) **Zusammenfassung**

Die vorliegende Erfindung betrifft die Verwendung von Bor- und Aluminium-Verbindungen in der Elektronik, insbesondere als Elektronentransportmaterial, als Wirts-Material der Emissionsschicht, als Lochblockierungs-Material jeweils in Phosphoreszenz-OLEDs, sowie daraus hergestellte Schichten in Phosphoreszenz-OLEDs.

## Beschreibung

Die vorliegende Erfindung betrifft die Verwendung von Bor- und Aluminium-Verbindungen in der Elektronik, insbesondere in Phosphoreszenz-OLED-Vorrichtungen.

In einer Reihe von verschiedenartigen Anwendungen, die im weitesten Sinne der Elektronikindustrie zugerechnet werden können, ist der Einsatz organischer Verbindungen als Wirkkomponenten (= Funktionsmaterialien) seit geraumer Zeit Realität bzw. wird in naher Zukunft erwartet.
So finden schon seit etlichen Jahren Ladungstransportmaterialien auf organischer Basis (i. d. R. Lochtransporter auf Triarylaminbasis) Verwendung in Kopiergeräten. Die Verwendung spezieller halbleitender organischer Verbindungen, die zum Teil auch zur Emission von Licht im sichtbaren Spektralbereich befähigt sind, steht gerade am Anfang der Markteinführung, zum Beispiel in Organischen-Elektrolumineszenz-Vorrichtungen.
Die Verwendung organischer Ladungstransportschichten in Anwendungen wie Organischen-Integrierten-Schaltungen (Organischen ICs) und Organischen-Solarzellen ist zumindest im Forschungsstadium schon sehr weit gediehen, so daß eine Markteinführung innerhalb der nächsten Jahre erwartet werden kann.
Die Anzahl weiterer Möglichkeiten ist sehr groß, häufig jedoch nur als Abwandlung der oben aufgeführten Prozesse zu sehen, wie die Beispiele Organische-Feststofflaserdioden und Organische-Photodetektoren belegen.
Bei einigen dieser modernen Anwendungen ist die Entwicklung teilweise bereits sehr weit fortgeschritten, dennoch besteht - je nach Applikation - immer noch ein immenser Bedarf an technischen Verbesserungen.

Bei den Organischen-Elektrolumineszenz-Vorrichtungen bzw. deren Einzelbauteilen, den Organischen-Lichtemittierenden-Dioden (OLEDs) ist die Markteinführung bereits erfolgt, wie die im Markt erhältlichen Auto-Radios mit "Organischem Display" der Firma Pioneer belegen. Weitere derartige Produkte stehen kurz vor der Einführung. Trotzallem sind hier noch deutliche Verbesserungen nötig um diese Displays zu einer echten Konkurrenz zu den derzeit marktbeherrschenden Flüssigkristallanzeigen (LCD) zu machen bzw. diese zu überflügeln.
Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, D. F. O'Brian, Y. You, A. Shoustikov, S. Sibley, M. E. Thompson, S. R. Forrest, Nature, **1998,** *395*, 151-154; M. A. Baldo, S. Lamansky, P. E. Burrows, M. E. Thompson, S. R. Forrest, Applied Physics Letters, **1999**, 75, 4-6], und die dadurch, aus theoretisch-statistischen Gründen, eine drei bis vierfache Energie- und Leistungseffizienz ergeben können. Ob sich diese neue Entwicklung durchsetzten wird, hängt allerdings stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Hierzu zählen z. B. eine hohe operative Lebensdauer, eine hohe Stabilität gegenüber Temperaturbelastung, eine niedrige Einsatz- und Betriebsspannung, um mobile Applikationen zu ermöglichen, um nur einige zu nennen.

Der allgemeine Aufbau von Organischen Elektrolumineszenzvorrichtungen ist beispielsweise in US 4,539,507 und US 5,151,629 beschrieben.

Üblicherweise besteht eine organische Elektrolumineszenzvorrichtung aus mehreren Schichten, die vorzugsweise mittels Vakuummethoden aufeinander aufgebracht werden. Diese Schichten sind im einzelnen eine:
1. Trägerplatte = Substrat (üblicherweise Glas oder Kunststoffolien).
2. Transparente Anode (üblicherweise Indium-Zinn-Oxid, ITO).
3. Lochinjektions-Schicht (**H**ole **I**njection **L**ayer = HIL): z. B. auf Basis von Kupferphthalocyanin (CuPc), leitfähige Polymere, wie Polyanilin (PANI), oder Polythiophen-Derivate (wie PEDOT).
4. Lochtransport-Schicht (**H**ole **T**ransport **L**ayer = HTL): üblicherweise auf Basis von Triarylamin-Derivaten.
5. Emissions-Schicht (**Em**ission **L**ayer = EML): diese Schicht kann teilweise mit den Schichten 4 oder 6 zusammenfallen, besteht aber üblicherweise aus mit Fluoreszenzfarbstoffen bzw. Phosphoreszenzfarbstoffen dotierten Wirtsmolekülen.
6. Elektronentransport-Schicht (**E**lectron **T**ransport **L**ayer = ETL): größtenteils auf Basis von Aluminium-tris-8-hydroxy-chinoxalinat (AlQ₃).
7. Elektroneninjektions-Schicht (**E**lectron **I**njection **L**ayer = EIL): diese Schicht kann teilweise mit der Schicht 6 zusammenfallen bzw. es wird ein kleiner Teil der Kathode speziell behandelt bzw. speziell abgeschieden.
8. Kathode: hier werden in der Regel Metalle, Metallkombinationen oder Metalllegierungen mit niedriger Austrittsfunktion verwendet so z. B. Ca, Ba, Mg, Al, In, Mg/Ag.

Diese ganze Vorrichtung wird natürlich entsprechend (je nach Anwendung) strukturiert, kontaktiert und schließlich auch hermetisch eingesiegelt, da sich i. d. R. die Lebensdauer derartiger Vorrichtungen bei Anwesenheit von Wasser und/oder Luft drastisch verringert.

Beim Anlegen einer entsprechenden Spannung werden von der Anode aus Löcher, von der Kathode aus Elektronen in die Vorrichtung injiziert, die sich im Device treffen und einen angeregten Zustand erzeugen. Dieser kann, unter Aussendung von Licht, zerfallen. Dieses Licht wird durch die transparente Anode ausgestrahlt. In einigen Anwendungen kann es auch sinnvoll sein, die Anordnung genau umzudrehen, d. h. eine (semi-)transparente Kathode zu benutzen, wenn die Anode z. B. auf einem intransparenten Substrat (beispielsweise einem Schalt-Chip aus Silizium) aufgebracht ist.
Für die neuartigen Phosphoreszenz-OLED Vorrichtungen kann es auch noch vorteilhaft sein, weitere dünne Schichten, die einzelne Ladungsträger blockieren (z. B. Lochblockierungsschichten = **H**ole **B**locking **L**ayer = HBL), einzufügen.

In jedem Fall wird die einzelne OLED Licht aussenden, welches eine Farbe aufweist, die die EML vorgibt. Auf diese Weise ist es möglich, je nach EML, die drei Grundfarben (blau, grün, rot) zu erzeugen.
Durch geeignete Kombination verschiedener einzelner OLEDs ist es nun möglich verschiedenartige Vorrichtungen, angefangen von einzelnen Leuchtdioden, über einfache segmentierte Anzeigen, über aufwendigere Matrix-Displays bis hin zu vollfarbigen, großformatigen Anzeigen/Bildschirmen zu produzieren.

Bei der oben erläuterten OLED Vorrichtung wurden bzw. werden die oben genannten Funktionsmaterialien intensiv optimiert.
Es fällt jedoch auf, daß in allen Vorrichtungen als ETL praktisch ausschließlich AlQ₃ Verwendung findet. Diese Verbindung wird auch, wie oben erwähnt, vielfach gleich noch als Wirt-Material für die EML verwendet. Es wurde zwar schon vielfach versucht, diese Verbindung durch andere Substanzen zu ersetzen, dies ist aber bis dato nicht geglückt.
AlQ₃ stellte sich bis lang immer noch als der beste Kompromiß für die verschiedenartigen Anforderungen dar. So weist die Verbindung neben einer hohen thermischen Stabilität (Glastemperatur Tg ∼ 180°C), eine offensichtlich brauchbare Bandlage und eine vertretbare Fluoreszenz-Quanteneffizienz im Feststoff (ca. 40%) auf. Negativ ist jedoch die Eigenfarbe (Absorption: gelb) der Verbindung, die gerade bei blauen OLEDs durch Fluoreszenzabsorption und Reemission zu Farbverschiebungen führen kann. Dies ist erst recht nachteilig bei dem oben erwähnten Device Aufbau, bei dem das Licht durch die Kathode, d. h. auch durch die ETL, ausgesendet wird. Hier sind blaue OLEDs nur mit starken Effizienz- bzw. Farborteinbußen darstellbar.
Auch die Verwendbarkeit von AlQ₃ in den neuartigen phosphoreszierenden OLEDs ist noch keineswegs abschließend geklärt.
Weiterer Nachteil des Einsatzes von AlQ₃ ist die inzwischen literaturbekannte Instabilität gegenüber Löchern [vgl. z. B. Z. Popovic et al., Proceedings of SPIE, **1999,** *3797*, 310-315], was bei einem langzeitigen Einsatz immer zu Problemen im Device führen kann.

Ein entscheidender praktischer Nachteil von AlQ₃ ist die starke Hygroskopie dieser Verbindung. AlQ₃, welches unter normalen Bedingungen synthetisiert und aufbewahrt wird, enthält neben den Hydroxychinolin-Liganden immer noch ein Molekül Wasser pro Komplex-Molekül [vgl. z.B.: H. Schmidbaur et al., Z. Naturforsch. **1991,** *46b*, 901-911]. Dieses ist extrem schwer zu entfernen. Für die Verwendung in OLEDs muß AlQ₃ deshalb in komplizierten, mehrstufigen, Sublimations-Verfahren aufwendig gereinigt, und im Anschluß daran unter Wasserausschluß in einer Schutzgasatmosphäre und gelagert und gehandhabt werden. Weiterhin wurden große Schwankungen in der Qualität einzelner AlQ₃ Chargen, sowie eine schlechte Lagerstabilität festgestellt (S. Karg, E-MRS Konferenz 30.5.00-2.6.00 Straßburg)

Für die neuartigen Phosphoreszenz-OLEDs wird zum einen ebenfalls AlQ₃ als ETL verwendet, zum anderen ist die Frage nach dem Wirtsmaterial für den eigentlichen Triplett-Emitter noch überhaupt nicht geklärt. Bis dato wurde nur die Verwendung von wenigen Materialien (4,4'-Biscarbazolyl-biphenyl, Poly-vinyl-carbazol, und einem Triazol-Derivat) berichtet. Gerade die operativen Lebensdauern sind allerdings noch stark optimierungsbedürftig.

Es wurde nun überraschend gefunden, daß gewisse Bor- oder
Aluminiumverbindungen hervorragende Eigenschaften bei der Verwendung als ETL, als HBL, bzw. als Wirtsmaterial in der EML aufzeigen. Gerade die Verwendung in den neuartigen Phosphoreszenz-OLED Vorrichtungen ist sehr vorteilhaft.
Die Verwendung dieser Verbindungen in Phosphoreszenz-Organischen Elektrolumineszenz-Vorrichtungen ist Gegenstand der vorliegenden Erfindung.

Die Verbindungen zeichnen sich, v. a. gegenüber AlQ₃ und den wenigen bis dato bekannten Wirtsmaterialien für Phosphoreszenz-OLEDs durch folgende Eigenschaften aus:
1. Sie sind farblos, bzw. nahezu farblos; dies bedeutet, daß ihre UV/VIS-Absorption im Wellenlängenbereich zwischen 400 und 700 nm vernachlässigbar gering ist. In erfindungsgemäßen Elektrolumineszenz-Vorrichtungen führt dies zu einer besseren Farbreinheit sowie höherer Effizienz. Dies hat den Vorteil, daß Sie vor allem bei blauen OLEDs zu keiner Farbverschiebung bzw. Effizienzerniedrigung führen. Ein weiterer Vorteil ist natürlich ihre Verwendung als Wirts- oder ETL-Material gerade in invertierten (vgl. oben) Device-Geometrien.
2. Die beschriebenen Bor- oder Aluminiumverbindungen - eingesetzt als Wirts- oder ETL-Material in den erfindungsgemäßen Elektroluminiszenz-Vorrichtungen - führen in diesen zu hohen Effizienzen, die insbesondere unabhängig von den verwendeten Stromdichten sind. Damit werden auch bei hohen Stromdichten sehr gute Effizienzen ermöglicht.
3. Die beschriebenen Bor- oder Aluminiumverbindungen zeichnen sich durch eine hohe Oxidationsstabilität aus. Dies kann bei Verwendung in entsprechenden erfindungsgemäßen Vorrichtungen zu einer deutlichen Erhöhung der operativen Lebensdauer führen. Weiterhin vereinfacht sich die Herstellung dieser Vorrichtungen.
4. Die beschriebenen Bor- oder Aluminiumverbindungen weisen keine erkennbare Hygroskopie auf sowie eine hohe Stabilität gegenüber Luftsauerstoff auf. Lagerung für mehrere Tage bzw. Wochen unter Zutritt von Luft und Wasserdampf führt zu keinen Veränderungen der Substanzen. Die Anlagerung von Wasser an die Verbindungen kann nicht nachgewiesen werden. Dies hat natürlich den Vorteil, daß die Substanzen unter einfacheren Bedingungen gereinigt, transportiert, gelagert und für den Einsatz vorbereitet werden können. Das Verwenden muß - im Gegensatz zu den Operationen beim AlQ₃ - nicht durchgehend unter Schutzgas stattfinden.
5. Die beschriebenen Bor- oder Aluminiumverbindungen sind gut reproduzierbar in verlässlicher hoher Reinheit herstellbar und weisen keine Chargenschwankung auf. Ein industrieller Prozess zur Herstellung der erfindungsgemäßen Elektrolumineszenzvorrichtungen ist daher wesentlich effizienter.
6. Die beschriebenen Bor- oder Aluminiumverbindungen zeichnen sich auch durch eine hohe Temperaturstabilität aus. Dies sei hier jedoch nicht als entscheidender Vorteil dargestellt, es soll lediglich darauf hingewiesen werden, daß auch diese Eigenschaft durch die Borane oder Aluminiumorganyle sehr zufriedenstellend erzielt wird.
7. Die beschriebenen Bor- oder Aluminiumverbindungen weisen eine exzellente Löslichkeit in organischen Lösungsmitteln auf. Damit sind diese Materialien auch aus Lösung durch Beschichtungs- oder Drucktechniken verarbeitbar. Auch bei der üblichen Verarbeitung durch Verdampfen ist diese Eigenschaft von Vorteil, da so das Reinigung der Anlagen bzw. der eingesetzten Schattenmasken erheblich erleichtert wird.

Die Verwendung Bor-haltiger Verbindungen in OLED Vorrichtungen ist bisher nur vereinzelt beschrieben.
So beschreibt Y. Shirota (z. B. Y. Shirota et al., Adv. Mater. **1999**, *11*, 283) eine Bisthiophen-bis-boranverbindung in OLEDs. Hier wird aber u. a. auf eine Exciplex-Bildung mit Lochtransportschichten hingewiesen, was auf eine morphologische Instabilität hindeutet.
In WO 00/40586 werden Monoboranverbindungen vorgestellt, die nach unseren
Untersuchungen nicht für den Einsatz in langlebigen OLEDs geeignet sind, da sie im Dauerbetrieb instabil sind. Dies ist vermutlich darauf zurück zuführen, daß die geladenen Spezies nicht vollständig stabil bzw. die thermische Stabilität dieser Verbindungen nicht hoch genug ist.
Des weiteren werden Oligoboryl-Verbindungen (hauptsächlich mit Anthracenbrücken bzw. -substituenten) vorgestellt, über die auch - von den gleichen Autoren - in *J*. *Am. Chem. Soc.,* **2000,** *122*, 6335 berichtet wird. Hier wird auch gleich ein deutlicher Nachteil dieser Verbindungen erkennbar: sie weisen eine starke Absorption im Bereich sichtbaren Lichts auf (vgl. o. g. Stelle, Fig. 2).
M. Tamano et al. berichten in JP-2000-290645 und JP-2000-290373 über verschiedene Boran-Verbindungen in OLED Anwendungen. Allerdings wird hier nichts über einen möglichen Einsatz in den o. g. neuartigen Phosphoreszenz-OLEDs berichtet.

Um als Elektrolumineszenzmaterialien Verwendung zu finden, werden die Bor- oder Aluminiumverbindungen, im allgemeinen nach bekannten, dem Fachmann geläufigen Methoden, wie Vakuumverdampfung, oder auch aus Lösung durch Spincoaten oder mit verschiedenen Druckverfahren (z. B. Tintenstrahldrucken, offset-Drucken, etc.), in Form eines Films auf ein Substrat aufgebracht.

Auch wenn die obigen Ausführungen hauptsächlich einen Einsatz der Bor- oder Aluminiumverbindungen in OLED Vorrichtungen beschreiben, sei darauf hingewiesen, daß diese Verbindungen ebenfalls sehr gut in folgenden Vorrichtungen Verwendung finden können:
1. Verwendung in Organischen-Solarzellen als Elektronenakzeptor- bzw. - transportmaterial.
2. Verwendung in Organischen ICs als Ladungstransportschicht.
3. Verwendung in weiteren - oben zum Teil genannten - Applikationen, wie Organischen-Feststofflasern oder Organischen-Photodetektoren.

### Gegenstand der vorliegenden Erfindung ist daher die Verwendung substituierter Bor- oder Aluminium-verbindungen der allgemeinen Formel (I)

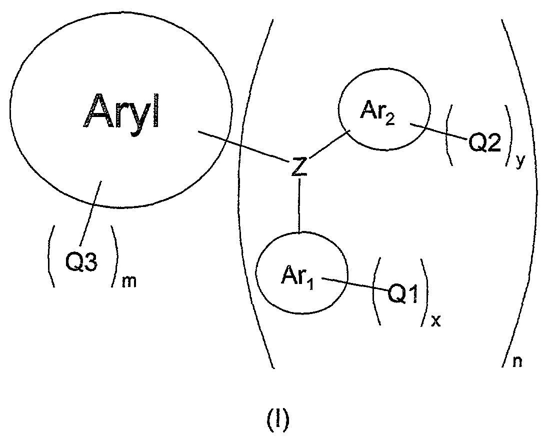

wobei die Symbole und Indizes folgende Bedeutungen haben:
- Aryl: ist ein Carbo- oder Heterocyclischer aromatischer Ring oder Ringsystem mit 2 bis 60 C Atomen, oder mehrere aromatische Ringe, mit jeweils 6 bis 14 C-Atomen, die durch eine konjugierte oder nichtkonjugierte Verknüpfung oder über ein oder mehrere Metallatome (Sandwich Komplex) miteinander verbunden sind;
- Ar₁, Ar₂: ist, gleich oder verschieden bei jedem Auftreten Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7-bzw. 8-Chinolinyl, 2- bzw. 3-Pyrrolyl, 2- bzw. 3-Furanyl und 2-(1,3,4-Oxadiazol)yl;
- Q1, Q2, Q3: ist, gleich oder verschieden bei jedem Auftreten und steht für CN, F, Cl oder eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹ -(NR²R³)⁺A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
- A⁻: ein einfach geladenes Anion oder dessen Äquivalent;
- R¹,R²,R³,R⁴: sind gleich oder verschieden, H oder ein aliphatischer oder aromatischer Kohlenwasserstoffrest mit 1 bis 20 C-Atomen;
- m: gleich oder verschieden 0, 1, 2, 3, 4, 5;
- x: gleich oder verschieden 0, 1, 2, 3, 4, 5;
- y: gleich oder verschieden 0, 1, 2, 3, 4, 5;
- n: 2, 3, 4, 5, 6;
- Z: Bor oder Aluminium,
in Phosphoreszenz-OLED-Vorrichtungen.

Die Bor- oder Aluminium-Verbindungen werden bevorzugt in Elektronentransportschichten (ETL), Lochblockierungsschichten (HBL) oder als Wirt-Systeme in der Emissionsschicht (EML) in den Phosphoreszenz-OLEDs verwendet. Als Dotierstoffe hierfür eignen sich Triplet-Emitter. Sie zeigen in diesen Anwendungen beispielsweise den Vorteil, daß sie im Dauerbetrieb auch bei erhöhten Temperaturen (z.B. mehrstündiges Erhitzen auf 130°C) eine konstante Helligkeit aufweisen. Weiterhin bleibt die für eine gegebene Helligkeit aufzuwendende Spannung weitgehend konstant. Somit ist es nicht notwendig, bei Dauerbetrieb die Spannung nachzuregulieren, um eine anfängliche Helligkeit zu erhalten. Dieser Vorteil macht sich insbesondere bei Batteriebetrieb bemerkbar, da hierbei die unter wirtschaftlichen Aspekten mögliche Höchstspannung stark eingeschränkt ist.
Ebenso weisen Vorrichtungen, welche die beschriebenen Bor- oder Aluminium - Verbindungen enthalten, eine lange Lebensdauer sowie eine hohe EL Effizienz auf.

Bevorzugt ist die Verwendung von Bor- oder Aluminium-Verbindungen, in denen Aryl im Formelbild (I) folgende Bedeutung hat: Benzol, Biphenyl, 1,2- bzw. 1,3- bzw. 1,4-Terphenyl, Tetraphenyl, Naphthalin, Fluoren, Phenanthren, 1,3,5-Triphenylbenzol, Pyren, Perylen, Chrysen, Trypticen, [2.2]Paracyclophan, Ferrocen, Pyridin, Pyridazin, 4,5-Benzo-pyridazin, Pyrimidin, Pyrazin, 1,3,5-Triazin, Pyrrol, Indol, 1,2,5- bzw. 1,3,4-Oxadiazol, 2,2'- bzw. 4,4'-Diazabiphenyl, Chinolin, Carbazol, 5,10H-Dihydro-phenazin, 10H-Phenoxazin, Xanthen, 9-Acridin.

Die übrigen Symbole und Indizes haben die oben genannte Bedeutung.

Besonders bevorzugt ist die Verwendung von Bor- oder Aluminium -Verbindungen gemäß Formel (I), in denen die Arylsubstituenten Ar₁ und Ar₂ jeweils gleich oder verschieden sind und für Phenyl, 1-Naphthyl, 2-Naphthyl stehen.
Die Stabilität, inbesondere gegen Oxidation - ist dann besonders hoch, wenn die Arylsubstituenten Ar₁, Ar₂ in ortho und ortho' Stellung mit C1 bis C20-Alkyl-, C1 bis C20-Alkyloxy- oder C4 bis C14-Aryl-Gruppen substituiert sind, sowie wenn das Z = Bor ist.

### Dementsprechend ist besonders bevorzugt die erfindungsgemäße Verwendung von Verbindungen gemäß Formel (II)

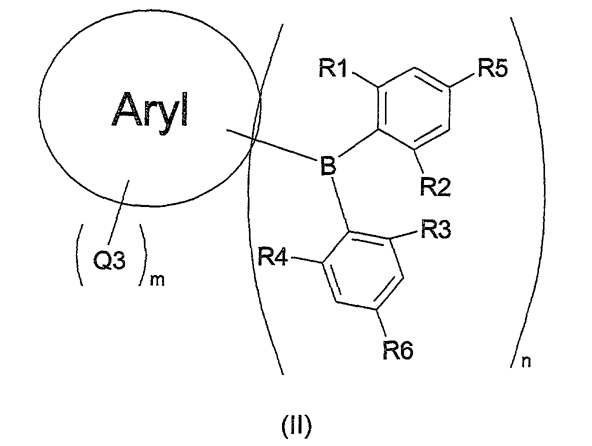

wobei die Symbole und Indizes folgende Bedeutungen haben:
- n: 2, 3, 4, 5, 6;
- R1,R2,R3,R4: ist jeweils gleich oder verschieden ein Alkyl, Alkyloxy oder Arylrest mit 1 bis 20 C-Atomen, sowie entsprechende Fluoralkyl-bzw. Fluoralkoxyreste;
- R5, R6: ist jeweils gleich oder verschieden H, CN, F, Cl, Br, I, eine geradkettige, verzweigte oder cyclische Alkyl- oder Alkoxygruppe, eine Thioalkyl- oder Thioarylgruppe, eine Nitrogruppe, eine Diaryl- oder Dialkylaminogruppe sowie eine Ester, Amid oder Carbonsäuregruppe.
- Q3: ist jeweils, gleich oder verschieden bei jedem Auftreten, CN, F, Cl oder eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
- A⁻: ein einfach geladenes Anion oder dessen Äquivalent;
- R¹,R²,R³,R⁴: sind jeweils gleich oder verschieden, Wasserstoff oder ein aliphatischer oder aromatischer Kohlenwasserstoffrest mit 1 bis 20 C-Atomen;
- m: 0, 1, 2, 3, 4, 5.

Insbesondere ist besonders bevorzugt die Verwendung von Verbindungen nach Formel (II), die durch zwei oder drei gleiche Bor-Substituenten charakterisiert sind. Hierbei haben besonders weitere Substituenten (R5, R6) mit Elektronendonor- oder Elektronenakzeptorwirkung in para-Stellung zum Bor einen deutlichen Einfluß auf die elektrischen und die elektrooptischen Eigenschaften der Verbindungen, so daß die elektrooptischen Eigenschaften durch eine geeignete Wahl dieser Substituenten maßgeschneidert werden können.

Einige Verbindungen, die erfindungsgemäß Verwendung finden, sind im folgenden genauer beschrieben.
- Aryl in Formelbild (I) bzw. (II) kann einem der untenstehenden substiuierten Benzolen entsprechen, 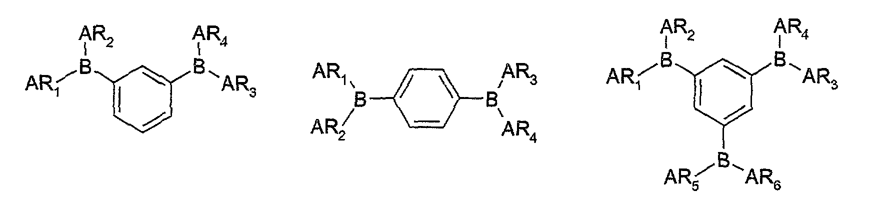 oder Aryl in Formelbild (I) bzw. (II) kann einem der untenstehenden substiuierten Biphenylen entsprechen, 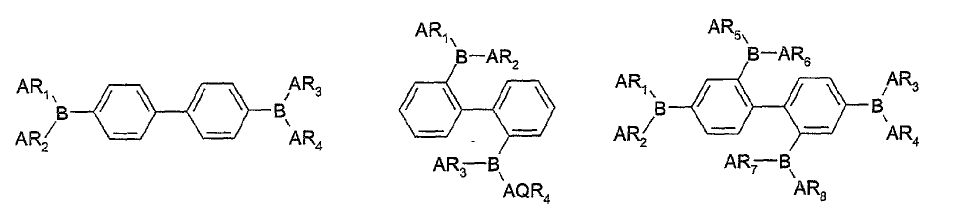 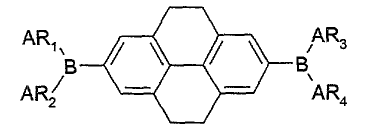 oder Aryl in Formelbild (I) bzw. (II) kann einem der untenstehenden substiuierten Terphenylen entsprechen, 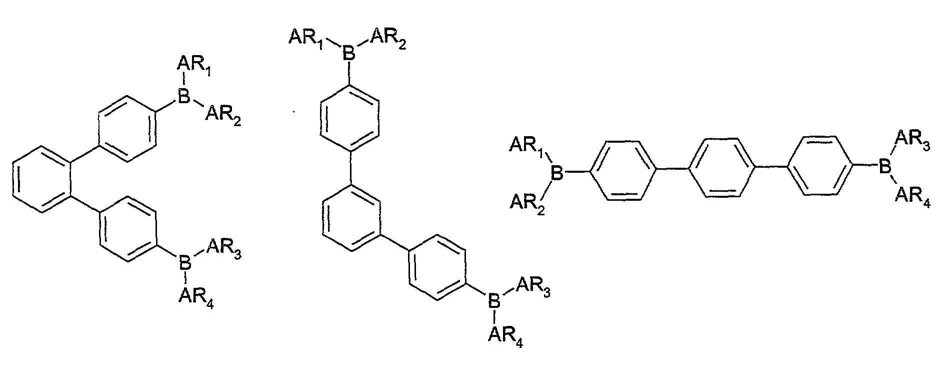 oder Aryl in Formelbild (I) bzw. (II) kann einem der untenstehenden substiuierten Naphthalinen entsprechen, 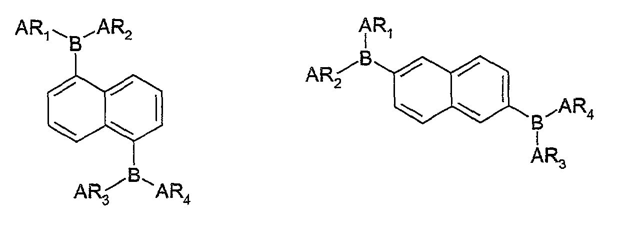 oder Aryl in Formelbild (I) bzw. (II) kann dem untenstehenden substiuierten Fluoren entsprechen, 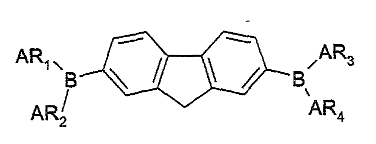 oder Aryl in Formelbild (I) bzw. (II) kann einem der untenstehenden substiuierten Phenanthrene entsprechen, 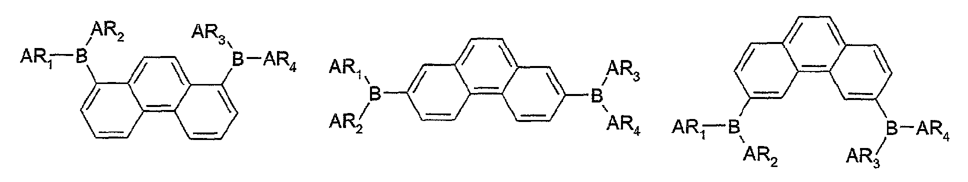 oder Aryl in Formelbild (I) bzw. (II) kann einem der untenstehenden substituierten 1,3,5-Triphenylbenzol, Pyren, Perylen, Chrysen, Trypticen, [2.2] Paracyclophan, 1,1 '-Ferrocen entsprechen, 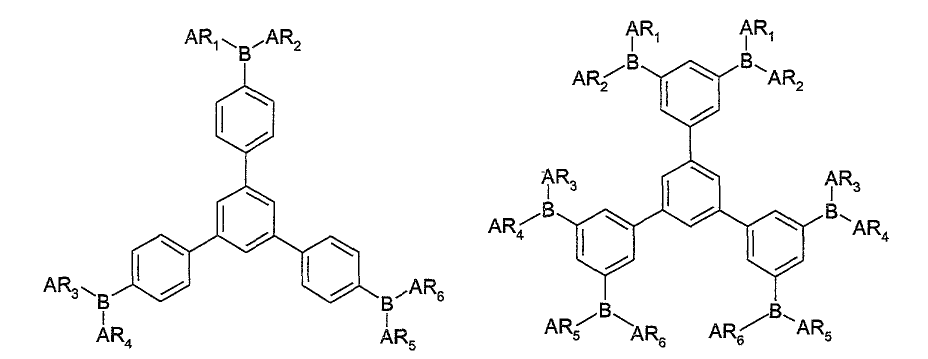 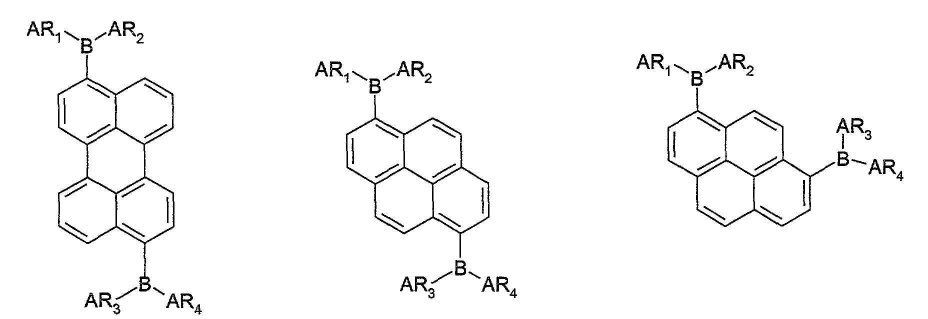 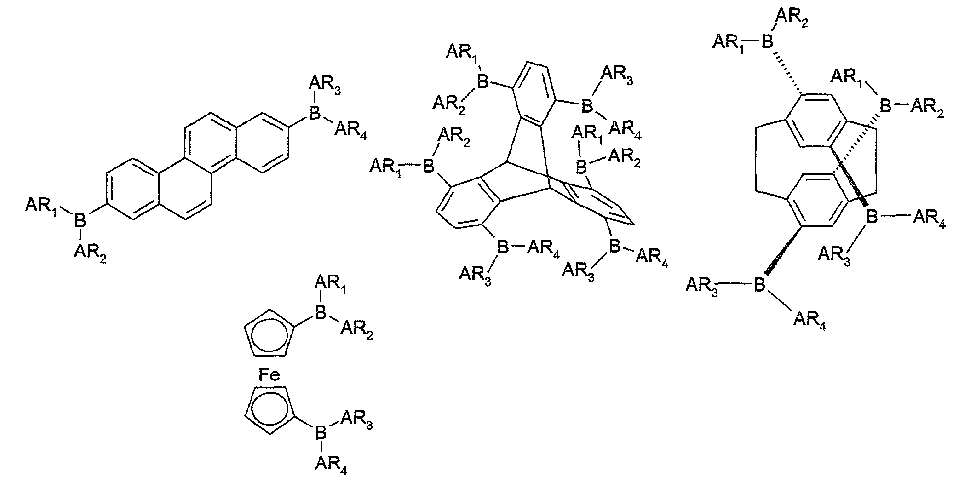 oder Aryl in Formelbild (I) bzw. (II) kann - wie bereits oben beschrieben auch ein Heteroaryl-Rest sein. Als exemplarische Beispiele seien nachfolgend genannt:
- Aryl in Formelbild (I) bzw. (II) kann einem der untenstehenden substiuierten Pyridine, Pyridazine, 4,5-Benzo-pyridazine, Pyrimidine, Pyrazine entsprechen, 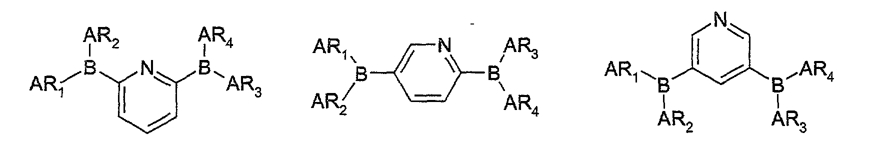 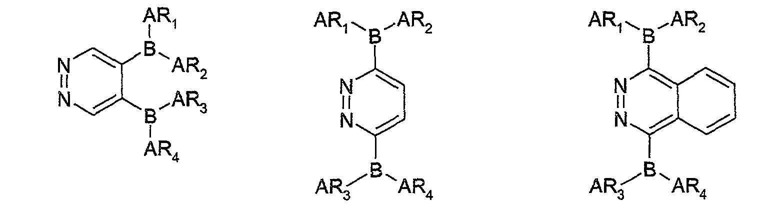 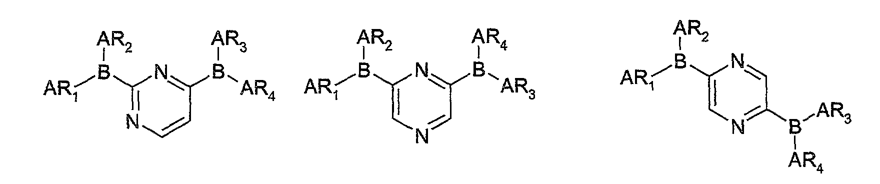 oder Aryl in Formelbild (I) bzw. (II) kann einem der untenstehenden substiuierten 1,3,5-Triazine, 1,2,5- bzw. 1,3,4-Oxadiazol entsprechen, 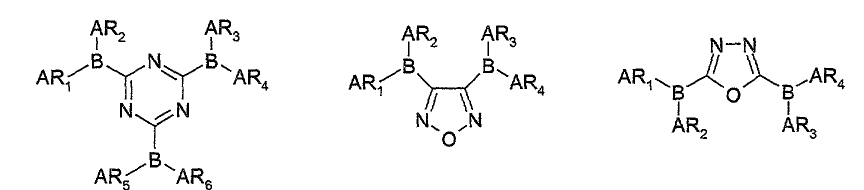 oder Aryl in Formelbild (I) bzw. (II) kann einem der untenstehenden substiuierten 2,2'-, bzw. 4,4'-Diazabiphenyle entsprechen, 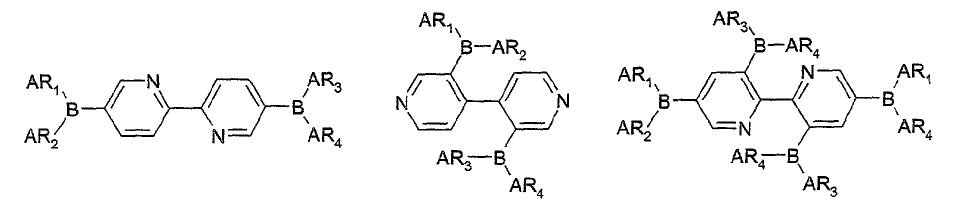 oder Aryl in Formelbild (I) bzw. (II) kann einem der untenstehenden substiuierten 2,7- bzw. 3,6-Carbazole, 5,10-Dialkyl-phenazin, 10-Alkyl-phenoxazin entsprechen:

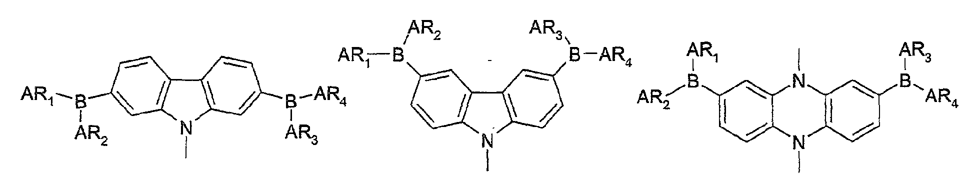

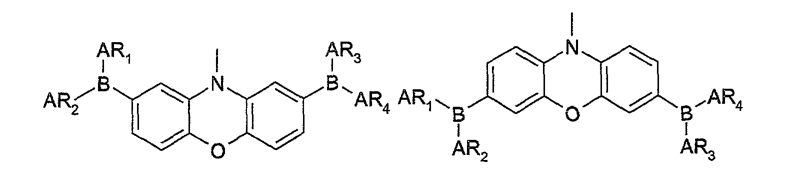

Die Reste AR₁ bis AR₈ haben jeweils die gleiche Bedeutung wie die Reste Ar₁ und Ar₂ in Formel (I).

Besonders bevorzugt stehen die Reste AR₁ bis AR₈ für folgende Reste:

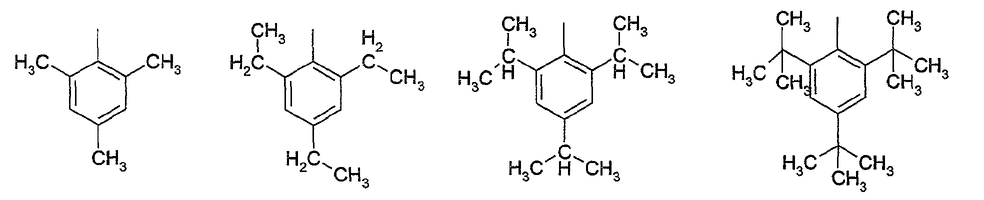

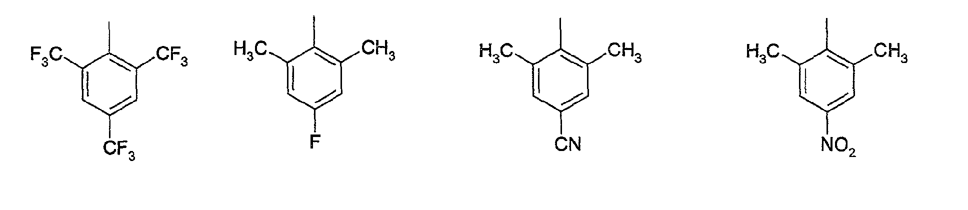

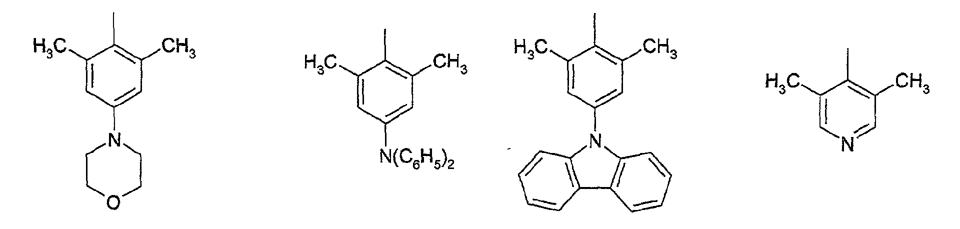

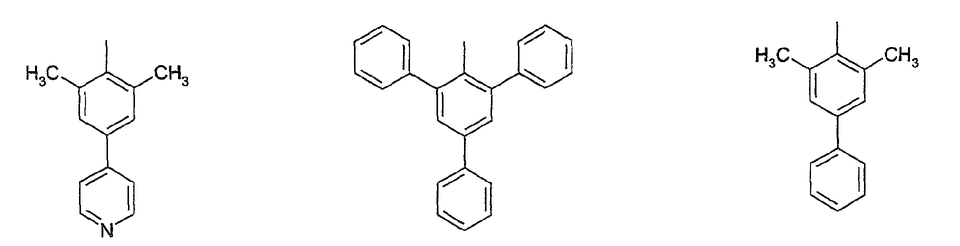

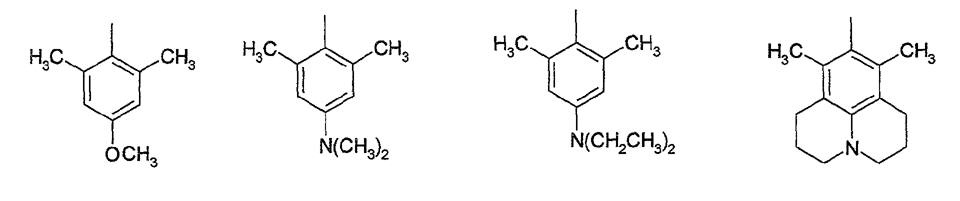

Besonders bevorzugt, wie in der technischen Erläuterung angegeben ist die Verwendung der aufgeführten und oben beschriebenen Verbindungen, wenn diese im sichtbaren Bereich (400 bis 700 nm) nicht oder kaum absorbieren.

Die Synthese von Bor-oder Aluminium-Verbindungen der Formeln (I) und (II) erfolgen beispielsweise durch Umsetzung eines halogenierten Aromaten (bevorzugt: Bromaromat) mit einem Metall (z.B. Li, Mg), einer Metall-Legierung (z.B. Li-Al-Legierung) oder einer Metallverbindung (*n*-, sec-, *tert*-Buthyllithium, Grignard-Verbingung) und darauf folgender salzmetathetischer Umsetzung mit einer Organobor-halogen- oder Organo-aluminium-halogen-verbindung. Besonders bewährt hat sich hierbei die Umsetzung eines lithiierten Aromaten mit

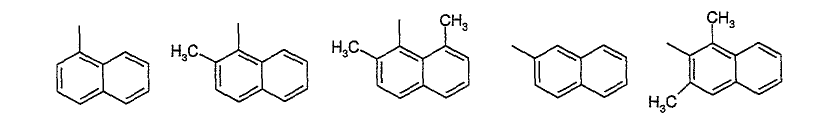

Diaryl Bor- oder Aluminium-Halogeniden, da nach diesem Verfahren - im Vergleich zu bereits in der Literatur beschriebenen Umsetzungen von Grignard-Verbindungen mit Diaryl Bor-Halogeniden [A. Schulz, W. Kaim, Chem. Ber., 1989, *122*, 1863-1868] - deutlich bessere Ausbeuten erzielt werden.
Die Synthese und Eigenschaften der oben beschriebenen, erfindungsgemäß zu verwendenden Bor- und Aluminiumverbindungen wird durch die nachfolgenden Beispiele erläutert, ist aber keinenfalls auf diese beschränkt.

### 1. Synthese von Bor- und Aluminium-Verbindungen :

Die nachfolgenden Synthesen wurden bis zur Aufarbeitung in sorgfältig getrockneten Reaktionsgefäßen unter einer trockenen Rein-Stickstoffatmosphäre oder -Argonatmosphäre unter Verwendung sorgfältig getrockneter Lösungsmittel durchgeführt. Die verwendeten Edukte wurden entweder bei ALDRICH (Methyilithium-Litiumbromid-Komplex 1.5 M in Diethylether, *n*-Butyllithium 1.6 M in *n*-Hexan, *tert*-Butyllithium 1.7 M in *n*-Hexan, 1,4-Dibrombenzol, 1,3-Dibrombenzol, 1,3,5-Tribrombenzol, 4,4'-Dibrombiphenyl, Ferrocen, 2,6-Dibrompyridin) bezogen und ohne weitere Reinigung verwendet bzw. nach Literaturvorschriften (Fluor-dimesitylboran: A. Pelter, B. Singaram, L. Warren, J. W. Wilson, Tetrahedron 1993, *49*, 2965-2978, 1,3,5-Tris(trimethylstannyl)benzol: N. Rot, F. J.J. de Kanter, F. Bickelhaupt, W. J.J. Smeets, A. L. Spek, J. Organomet. Chem. 2000, *593-594*, 369-379, Lithium-4,4'-di-*tert*-butylbiphenyl: P. K. Freeman, L. L. Hutchinson, J. Org. Chem. 1980, *45*, 1924) hergestellt.

### Beispiel 1: Synthese von 1,4-Bis(dimesitylboryl)benzol

Eine auf -78°C gekühlte, gut gerührte Lösung von 2.36 g (10 mmol) 1,4-Dibrombenzol in 200 ml absolutem THF wurde während 20 min tropfenweise so mit 25.9 ml (44 mmol) einer 1.7 M Lösung von *tert*-Butyllithium in *n*-Hexan versetzt, daß die Temperatur der Reaktionsmischung -65°C nicht überschritt. Die Lösung wurde 1 h bei -78°C nachgerührt und dann tropfenweise mit einer Lösung von 6.44 g (24 mmol) Fluor-dimesitylboran in 50 ml absolutem THF so während 20 min versetzt, daß die Temperatur der Reaktionsmischung -65°C nicht überschritt.

Man ließ die Reaktionsmischung unter Rühren während 12 Stunden auf
Raumtemperatur erwärmen. Anschließend wurde das THF am Rotationsverdampfer entfernt, der gelbe, halbfeste Rückstand wurde in 200 ml Dichlormethan aufgenommen, die organische Phase die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das gelbe Rohprodukt (ca. 5.5 g, Reinheit nach HPLC: 90 - 95 % ig) wurde wiederholt aus *n*-Hexan umkristallisiert, bis eine Reinheit von 99.8 % nach HPLC erreicht wurde. Die Ausbeute - bei einer Reinheit von 99.8% nach HPLC - betrug 3.9 g entsprechend 67.8 %.
¹H NMR (CDCl₃): [ppm] = 7.43 (s, H-*p*-Phenylen, 4 H), 6.79 (br. s, H-Mes, 8 H), 2.29 (s, CH₃, 12 H), 1.98 (s, CH₃, 24 H).
Thermische Daten (aus DSC): T_{g} ∼ 100°C, Tₘ = 269°C.

### Beispiel 2: Synthese von 1,3-Bis(dimesitylboryl)benzol

Eine auf -78°C gekühlte, gut gerührte Lösung von 2.36 g (10 mmol) 1,3-Dibrombenzol in 200 ml absolutem THF wurde während 20 min tropfenweise so mit 25.9 ml (44 mmol) einer 1.7 M Lösung von *tert*-Butyllithium in *n*-Hexan versetzt, daß die Temperatur der Reaktionsmischung -65°C nicht überschritt. Die Lösung wurde 1 h bei -78°C nachgerührt und dann tropfenweise mit einer Lösung von 6.44 g (24 mmol) Fluor-dimesitylboran in 50 ml absolutem THF so während 20 min versetzt, daß die Temperatur der Reaktionsmischung -65°C nicht überschritt.
Man ließ die Reaktionsmischung unter Rühren während 12 Stunden auf Raumtemperatur erwärmen. Anschließend wurde das THF am Rotationsverdampfer entfernt, der gelbe, halbfeste Rückstand wurde in 200 ml Dichlormethan aufgenommen, die organische Phase die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das gelbe Rohprodukt (ca. 5.5 g, Reinheit nach HPLC: 93 - 96 % ig) wurde wiederholt aus Ethylacetat / *n*-Hexan umkristallisiert, bis eine Reinheit von 99.8 % nach HPLC erreicht wurde. Die Ausbeute - bei einer Reinheit von 99.8% nach HPLC - betrug 2.7 g entsprechend 47.0 %.
¹H NMR (CDCl₃): [ppm] = 7.53 (dd, H-4, H-6, ³J_{HH} = 7.3 Hz, ⁴J_{HH} = 1.3 Hz, 2H), 7.48 (br. s, H-2, 1 H), 7.33 (dt, H-5, ³J_{HH} = 7.3 Hz, ⁵J_{HH} = 0.6 Hz, 1H), 6.78 (br. s, H-Mes, 8 H), 2.28 (s, CH₃, 12 H), 1.95 (s, CH₃, 24 H).
Thermische Daten (aus DSC): T_{g} ∼ 87°C, Tₘ = 169°C.

### Beispiel 3: Synthese von 1,3,5-Tris(dimesitylboryl)benzol

### Variante A:

Eine auf -78°C gekühlte, gut gerührte Lösung von 5.67 g (10 mmol) 1,3,5-Tris(trimethylstannyl)benzol in 300 ml absolutem THF wurde während 15 min tropfenweise mit 40.0 ml (60 mmol) einer 1.5 M Lösung von Methyllithium-Lithiumbromid-Komplex in Diethylether versetzt. Anschließend wurde die Reaktionsmischung auf -50°C erwärmt, 45 min. bei -50°C gerührt, erneut auf -78°C abgekühlt und dann tropfenweise mit einer Lösung von 16.09 g (60 mmol) Fluor-dimesitylboran in 150 ml absolutem THF so während 20 min versetzt, daß die Temperatur der Reaktionsmischung -65°C nicht überschritt. Man ließ die Reaktionsmischung unter Rühren während 12 Stunden auf Raumtemperatur erwärmen. Anschließend wurde das THF am Rotationsverdampfer entfernt, der gelbe, halbfeste Rückstand wurde in 200 ml Dichlormethan aufgenommen, die organische Phase die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das gelbe Rohprodukt (ca. 8 g, Reinheit nach HPLC: 70-75 % ig) wurde wiederholt aus Ethylacetat /*n*-Hexan umkristallisiert, bis eine Reinheit von 99.8 % nach HPLC erreicht wurde. Die Ausbeute - bei einer Reinheit von 99.8% nach HPLC - betrug 4.4 g entsprechend 53.4 %.

### Variante B:

Eine auf -78°C gekühlte, gut gerührte Lösung von 3.15 g (10 mmol) 1,3,5-Tribrombenzol in 300 ml absolutem THF wurde während 15 min tropfenweise mit 140.0 ml (70 mmol) einer 0.5 M Lösung von Lithium-4,4'-di-*tert*-butylbiphenyl in THF versetzt. Anschließend wurde die Reaktionsmischung auf -40°C erwärmt, 45 min. bei -40°C gerührt. Die blaugrüne Reaktionsmischung wurde tropfenweise mit einer 0.25 M Lösung von *tert*-Butylchlorid in THF versetzt bis ein Farbumschlag nach braun eintrat. Anschließend wurde die Lösung erneut auf -78°C abgekühlt und dann tropfenweise mit einer Lösung von 10.73 g (40 mmol) Fluor-dimesitylboran in 100 ml absolutem THF so während 20 min versetzt, daß die Temperatur der Reaktionsmischung -65°C nicht überschritt. Man ließ die Reaktionsmischung unter Rühren während 12 Stunden auf Raumtemperatur erwärmen. Anschließend wurde das THF am Rotationsverdampfer entfernt, der gelbe, haibfeste Rückstand wurde in 200 ml Dichlormethan aufgenommen, die organische Phase die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das gelbe Rohprodukt (ca. 8 g, Reinheit nach HPLC: 80-85 % ig) wurde wiederholt aus Ethylacetat / *n*-Hexan umkristallisiert, bis eine Reinheit von 99.8 % nach HPLC erreicht wurde. Die Ausbeute - bei einer Reinheit von 99.8% nach HPLC - betrug 5.1 g entsprechend 62.0 %.
¹H NMR (CDCl₃): [ppm] = 7.51 (s, H-2, H-4, H-6, 3 H), 6.73 (br. s, H-Mes, 12 H), 2.29 (s, CH₃, 18 H), 1.88 (s, CH₃, 36 H).
Thermische Daten (aus DSC): T_{g} ∼ 98°C, Tₘ = 239°C.

### Beispiel 4: Synthese von 4,4'-Bis(dimesitylboryl)biphenyl

Eine auf -78°C gekühlte, gut gerührte Suspension von 3.12 g (10 mmol) 4,4'-Dibrombiphenyl in 200 ml absolutem THF wurde während 20 min tropfenweise so mit 28.5 ml (48 mmol) einer 1.7 M Lösung von *tert*-Butyllithium in *n*-Hexan versetzt, daß die Temperatur der Reaktionsmischung -65°C nicht überschritt. Die Suspension wurde 1 h bei -78°C nachgerührt und dann tropfenweise mit einer Lösung von 6.44 g (24 mmol) Fluor-dimesitylboran in 100 ml absolutem THF so während 20 min versetzt, daß die Temperatur der Reaktionsmischung -65°C nicht überschritt.
Man ließ die Reaktionsmischung unter Rühren während 12 Stunden auf Raumtemperatur erwärmen. Anschließend wurde das THF am Rotationsverdampfer entfernt, der gelbe, halbfeste Rückstand wurde in 400 ml Dichlormethan aufgenommen, die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt.

Das gelbe Rohprodukt (ca. 6.5 g, Reinheit nach HPLC: 95 - 98 % ig) wurde wiederholt aus Dioxan und Chloroform umkristallisiert, bis eine Reinheit von 99.9 % nach HPLC erreicht wurde. Die Ausbeute - bei einer Reinheit von 99.9% nach HPLC - betrug 4.3 g entsprechend 66.0 %.
¹H NMR (CDCl₃): [ppm] = 7.64, 7.58 (d, H-2- und H-3-Biphenylen, ²J_{HH} = 8.4 Hz, 8 H), 6.83 (br. s, H-Mes, 8 H), 2,31 (s, CH₃, 12 H), 2.03 (s, CH₃, 24 H).
Thermische Daten (aus DSC): T_{g} ∼ 114°C, Tₘ = 263°C.

### Beispiel 5: Synthese von 1,1'-Bis(dimesitylboryl)ferrocen

Eine Mischung aus 2.87 g = 3.7 ml (24.7 mmol) N,N,N',N'-Tetramethylethylendiamin und 4 ml *n*-Hexan wurde unter Rühren bei Raumtemperatur mit 15.4 ml (24.7 mmol) einer 1.6 M Lösung von *n*-Butyllithium in *n*-Hexan während 5 min tropfenweise versetzt. Die Reaktionsmischung wurde 20 min. bei Raumtemperatur nachgerührt und dann tropfenweise während 25 min mit einer Lösung von 1.86 g (10 mmol) Ferrocen in 70 ml *n*-Hexan versetzt. Die Reaktionsmischung wurde 6 h bei Raumtemperatur gerührt und dann tropfenweise während 30 min mit einer Lösung von 6.62 g (24.7 mmol) Fluor-dimesitylboran in *n*-Hexan versetzt. Nach 16 h Rühren bei Raumtemperatur wurde das *n*-Hexan am Rotationsverdampfer entfernt, der rote, halbfeste Rückstand wurde in 400 ml Dichlormethan aufgenommen, die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das rote Rohprodukt (ca. 6.8 g, Reinheit nach HPLC: 95 - 98 % ig) wurde ein mal mit *n*-Hexan heiß ausgerührt und anschließend aus Ethanol umkristallisiert, bis eine Reinheit von 99.8 % nach HPLC erreicht wurde. Die Ausbeute - bei einer Reinheit von 99.8% nach HPLC - betrug 4.7 g entsprechend 68.8 %.
¹H NMR (CDCl₃): [ppm] = 6.75 (br. s, H-Mes, 8 H), 4.74, 4.42 (s, H-Cp, 8 H), 2.28 (br. s, CH₃, 36 H).

### Beispiel 6: Synthese von 2,6-Bis(dimesitylboryl)pyridin

30 ml auf -78°C abgekühltes THF wurde unter Rühren mit 15.0 ml (24 mmol) einer 1.6 M Lösung von *n*-Butyllithium in *n*-Hexan während 5 min tropfenweise versetzt. Zu diesem Gemisch wurde eine Lösung von 2.37 g (10 mmol) 2,6-Dibrompyridin in 70 ml THF unter Rühren während 15 min so zugetropft, daß die Temperatur -65°C nicht überstieg. Die Reaktionsmischung wurde weitere 15 min bei -78°C gerührt und dann tropfenweise während 30 min mit einer Lösung von 6.44 g (24 mmol) Dimesitylboran fluorid in 100 ml THF versetzt.
Man ließ die Reaktionsmischung unter Rühren während 12 Stunden auf Raumtemperatur erwärmen. Anschließend wurde das THF am Rotationsverdampfer entfernt, der gelbe, halbfeste Rückstand wurde in 400 ml Dichlormethan aufgenommen, die organische Phase wurde mit 3 ml Wasser versetzt, 30 min intensiv gerührt und anschließend über Magnesiumsulfat getrocknet. Nach Abfiltrieren des Trockenmittels wurde die organische Phase zur Trockene eingeengt. Das gelbe Rohprodukt (ca. 5.7 g, Reinheit nach HPLC: 96 - 97 % ig) wurde wiederholt aus Chloroform bzw. Ethylacetat / Ethanol umkristallisiert, bis eine Reinheit von 99.9 % nach HPLC erreicht wurde. Die Ausbeute - bei einer Reinheit von 99.9% nach HPLC - betrug 3.6 g entsprechend 62.6 %.
¹H NMR (CDCl₃): [ppm] = 8.14, (t, H-3, ³J_{HH} = 6.3 Hz, 1 H), 7.63 (d, H-2, ³J_{HH} = 6.3 Hz, 2 H), 6.90 (br. s, H-Mes, 8 H), 2.33 (s, CH₃, 12 H), 2.10 (s, CH₃, 24 H).

### 2. Herstellung und Charakterisierung von Phosphoreszenz OLED Vorrichtungen, die erfindungsgemäße Verbindungen enthalten.

Die Herstellung von LEDs erfolgte nach dem im folgenden skizzierten allgemeinen Verfahren. Dieses mußte natürlich im Einzelfall auf die jeweiligen Gegebenheiten (z. B. Schichtdickenvariation um optimale Effizienz bzw. Farbe zu erreichen) angepaßt werden.

### Allgemeines Verfahren zur Herstellung von OLEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser, Isopropanol).

Zur Trocknung werden sie mit einer N₂-Pistole abgepustet und in einem Exsikkator gelagert. Vor der Bedampfung mit den organischen Schichten werden sie mit einem Ozon-Plasma-Gerät für ca. 20 Minuten behandelt. Es kann sich empfehlen, als erste organische Schicht eine polymere Lochinjektionsschicht zu verwenden. Dies ist in der Regel ein konjugiertes, leitfähiges Polymer, wie z. B. ein Polyanilinderivat (PANI) oder eine Polythiophenderivat (z. B. PEDOT von BAYER). Diese wird dann durch Spin-Coaten (Lackschleudern) aufgebracht.
Die organischen Schichten werden der Reihe nach durch Aufdampfen in einer Hochvakuum-Anlage aufgebracht. Dabei wird die Schichtdicke der jeweiligen Schicht und die Bedampfungsrate genau über einen Schwingquarz verfolgt bzw. eingestellt.
Es können auch - wie oben beschrieben - einzelne Schichten aus mehr als einer Verbindung bestehen, d. h. in der Regel ein Wirtsmaterial (host) mit einem Gastmaterial (guest) dotiert sein. Dies wird durch Co-Verdampfung aus zwei bzw. mehreren Quellen erzielt.
Auf die organischen Schichten werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ca, Yb, Ba-AI) als Kathode kontaktiert und die Device-Parameter bestimmt.

## Patentansprüche

1. Verwendung substituierter Bor- oder Aluminium-verbindungen der allgemeinen Formel (I) 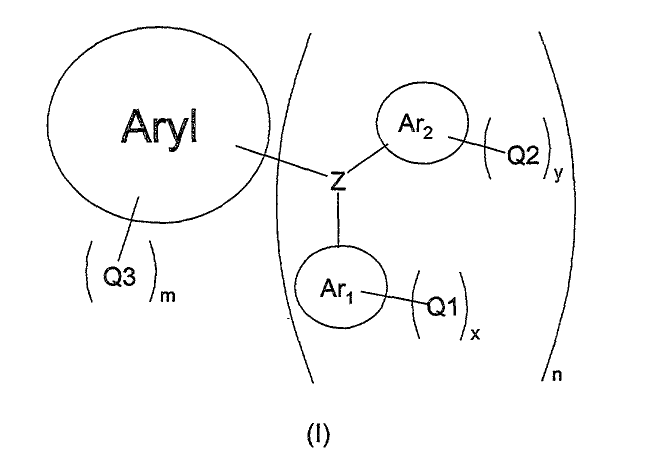 wobei die Symbole und Indizes folgende Bedeutungen haben:
Aryl ist ein Carbo- oder Heterocyclischer aromatischer Ring oder Ringsystem mit 2 bis 60 C Atomen, oder mehrere aromatische Ringe, mit jeweils 6 bis 14 C-Atomen, die durch eine konjugierte oder nichtkonjugierte Verknüpfung oder über ein oder mehrere Metallatome (Sandwich Komplex) miteinander verbunden sind;
Ar₁, Ar₂ ist, gleich oder verschieden bei jedem Auftreten Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolinyl, 2- bzw. 3-Pyrrolyl, 2- bzw. 3-Furanyl und 2-(1,3,4-Oxadiazol)yl;
Q1, Q2, Q3 ist, gleich oder verschieden bei jedem Auftreten und steht für CN, F, Cl oder eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹- -(NR²R³)⁺A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
A⁻ ein einfach geladenes Anion oder dessen Äquivalent;
R¹,R²,R³,R⁴ sind gleich oder verschieden, H oder ein aliphatischer oder aromatischer Kohlenwasserstoffrest mit 1 bis 20 C-Atomen;
m gleich oder verschieden 0, 1, 2, 3, 4, 5;
x gleich oder verschieden 0, 1, 2, 3, 4, 5;
y gleich oder verschieden 0, 1, 2, 3, 4, 5;
n 2, 3, 4, 5, 6;
Z Bor oder Aluminium,
in Phosphoreszenz-OLED-Vorrichtungen.

2. Verwendung gemäß Anspruch 1, **dadurch gekennzeichnet, daß** der Rest Aryl für Benzol, Biphenyl, 1,2- bzw. 1,3- bzw. 1,4-Terphenyl, Tetraphenyl, Naphthalin, Fluoren, Phenanthren, 1,3,5-Triphenylbenzol, Pyren, Perylen, Chrysen, Trypticen, [2.2]Paracyclophan, Ferrocen, Pyridin, Pyridazin, 4,5-Benzo-pyridazin, Pyrirnidin, Pyrazin, 1,3,5-Triazin, Pyrrol, Indol, 1,2,5- bzw. 1,3,4-Oxadiazol, 2,2'- bzw. 4,4'-Diazabiphenyl, Chinolin, Carbazol, 5,10H-Dihydro-phenazin, 10H-Phenoxazin, Xanthen oder 9-Acridin steht.

3. Verwendung gemäß Anspruch 1 oder 2, **dadurch gekennzeichnet, daß** die Reste Ar₁ und Ar₂ jeweils gleich oder verschieden sind und für Phenyl, 1-Naphthyl oder 2-Naphthyl stehen.

4. Verwendung gemäß einem oder mehreren der Ansprüche 1 bis 3, **dadurch gekennzeichnet, daß** Z für Bor steht.

5. Verwendung von Verbindungen gemäß Formel (II) in Phosphoreszenz-OLED-Vorrichtungen 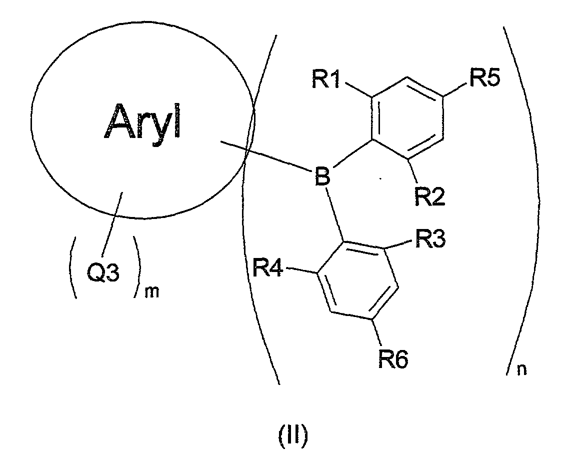 wobei die Symbole und Indizes folgende Bedeutungen haben:
n 2, 3, 4, 5, 6;
R1,R2,R3,R4 ist jeweils gleich oder verschieden ein Alkyl, Alkyloxy oder Arylrest mit 1 bis 20 C-Atomen, sowie entsprechende Fluoralkyl-bzw. Fluoralkoxyreste;
R5, R6 ist jeweils gleich oder verschieden H, CN, F, Cl, Br, I, eine geradkettige, verzweigte oder cyclische Alkyl- oder Alkoxygruppe, eine Thioalkyl- oder Thioarylgruppe, eine Nitrogruppe, eine Diaryl- oder Dialkylaminogruppe sowie eine Ester, Amid oder Carbonsäuregruppe.
Q3 ist jeweils, gleich oder verschieden bei jedem Auftreten, CN, F, Cl oder eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
A⁻ ein einfach geladenes Anion oder dessen Äquivalent;
R¹,R²,R³,R⁴ sind jeweils gleich oder verschieden, Wasserstoff oder ein aliphatischer oder aromatischer Kohlenwasserstoffrest mit 1 bis 20 C-Atomen;
m 0, 1, 2, 3, 4, 5.

6. Verwendung von Verbindungen gemäß Anspruch 5, **dadurch gekennzeichnet, daß** mindestens zwei Bor-Substituenten gleich sind.

7. Verwendung von Verbindungen gemäß Anspruch 6, **dadurch gekennzeichnet, daß** mindestens drei Bor-Substituenten gleich sind.

8. Verwendung der gemäß einem oder mehreren der Ansprüche 1 bis 7 definierten Verbindungen als Elektronentransportmaterial in Phosphoreszenz-OLEDs.

9. Verwendung der gemäß einem oder mehreren der Ansprüche 1 bis 7 definierten Verbindungen als Wirts-Material der Emissionsschicht in Phosphoreszenz-OLEDs.

10. Verwendung der gemäß einem oder mehreren der Ansprüche 1 bis 7 definierten Verbindungen als Lochblockierungs-Schicht in Phosphoreszenz-OLEDs.

11. Elektronentransportmaterial in Phosphoreszenz-OLEDs enthaltend mindestens eine der in den Ansprüchen 1 bis 7 definierten Verbindungen.

12. Wirts-Material der Emissionsschicht in Phosphoreszenz-OLEDs enthaltend mindestens eine der in den Ansprüchen 1 bis 7 definierten Verbindungen.

13. Lochblockierungs-Schicht in Phosphoreszenz-OLEDs enthaltend mindestens eine der in den Ansprüchen 1 bis 7 definierten Verbindungen.
